# EUROPÄISCHE PATENTSCHRIFT

(11) **EP 2 829 581 B1**
(45) Veröffentlichungstag und Bekanntmachung des Hinweises auf die Patenterteilung: **28.10.2015**
(21) Anmeldenummer: 14159605.6
(22) Anmeldetag: 13.03.2014
(51) Int. Cl.: C09D 5/00

(54) **VERFAHREN ZUR BESCHICHTUNG EINER GEBÄUDEOBERFLÄCHE, INSBESONDERE EINER WAND-, DECKEN- ODER EINER BODENOBERFLÄCHE EINES GEBÄUDES**
METHOD FOR COATING THE SURFACE OF A BUILDING, IN PARTICULAR A WALL, CEILING OR A FLOOR SURFACE OF A BUILDING
PROCÉDÉ DE REVÊTEMENT D'UNE SURFACE DE BÂTIMENT, NOTAMMENT D'UNE SURFACE DE MUR, DE PLAFOND OU DE SOL D'UN BÂTIMENT

(30) Priorität: 12.04.2013 DE 102013006286
(43) Veröffentlichungstag der Anmeldung: 28.01.2015
(73) Patentinhaber: STO SE & Co. KGaA, 79780 Stühlingen (DE)
(72) Erfinder: Grebner, Michael, 61389 Seelenberg (DE); Meier, Jan-Karsten, 45259 Essen (DE)
(74) Vertreter: Gottschalk, Matthias

(56) Entgegenhaltungen:
- EP-A1- 1 600 688
- WO-A1-2009/106067
- DE-A1-102006 060 781
- DE-A1-102007 039 416
- DE-A1-102007 054 037

## Beschreibung

Die Erfindung betrifft ein Verfahren zur Beschichtung einer Gebäudeoberfläche, insbesondere einer Wand-, Decken- oder Bodenoberfläche eines Gebäudes, mit den Merkmalen des Oberbegriffs des Anspruchs 1. Bei diesem Verfahren werden lichtemittierende Elemente, insbesondere organische lichtemittierende Dioden, in die Beschichtung integriert.

### Stand der Technik

Die Entwicklung neuartiger Leuchtmittel, die kleinvolumig, langlebig sind und zudem wenig Energie verbrauchen, ist weit vorangeschritten. Zu derartigen Leuchtmitteln zählen vorrangig lichtemittierende Dioden (LEDs), insbesondere organische lichtemittierende Dioden (OLEDs). Sie gelangen in Anzeigevorrichtungen, beispielsweise in Displays und Monitoren, sowie in Beleuchtungsanordnungen zum Einsatz.

Aus der DE 10 2008 023 874 A1 ist zum Beispiel eine strahlungsemittierende Anordnung bekannt, die ein Trägerelement mit einer zumindest teilweisen nicht transparenten Hauptoberfläche und ein auf dem Trägerelement angeordnetes, organisches strahlungsemittierendes Bauelement mit einer organischen Schichtenfolge mit einem aktiven Bereich zwischen einer zumindest teilweise transparenten ersten Elektrode und einer zumindest teilweisen transparenten zweiten Elektrode umfasst, wobei die Anordnung derart ausgebildet ist, dass in einem ausgeschalteten Betriebszustand des organischen strahlungsemittierenden Bauelements die zumindest teilweise nicht transparente Hauptoberfläche des Trägerelements von einem externen Beobachter wahrnehmbar bleibt. Das Trägerelement kann eine Wand oder eine Decke sein, welche gemeinsam mit dem organischen strahlungsemittierenden Bauelement eine strahlungsemittierende Anordnung ausbildet. Die Wand oder Decke kann eine Beschichtung aufweisen, welche die Hauptoberfläche des Trägerelements bildet, d. h. Bestandteil des Trägerelements ist. Ferner wird in dieser Druckschrift vorgeschlagen, dass zwischen dem organischen strahlungsemittierenden Bauelement und dem Trägerelement eine Zwischenschicht ausgebildet ist, die beispielsweise der Befestigung des organischen strahlungsemittierenden Bauelements dient. Bei dem organischen strahlungsemittierenden Bauelement kann es sich insbesondere um eine organische strahlungsemittierende Diode (OLED) handeln. Mittels der vorgeschlagenen strahlungsemittierenden Anordnung sollen Beleuchtungselemente geschaffen werden, die eine bestimmte Wirkung oder Oberflächenbeschaffenheit eines Trägerelementes gezielt hervorzuheben vermögen.

Der vorliegenden Erfindung liegt die Aufgabe zugrunde, einen weiteren Anwendungsbereich für die neuartigen Leuchtmittel, insbesondere für organische lichtemittierende Dioden (OLEDs), zu eröffnen, indem ein Verfahren zur Beschichtung einer Gebäudeoberfläche, insbesondere einer Wand-, Decken- oder Bodenoberfläche, vorgeschlagen wird, bei welchem lichtemittierende Elemente, insbesondere organische lichtemittierende Dioden, in die Beschichtung integriert werden. Auf diese Weise lassen sich Wand-, Decken- oder Bodenoberflächen herstellen, die zur Raumbeleuchtung, zur Informationswiedergabe und/oder zu dekorativen Zwecken Licht emittieren. Zugleich soll eine ebene Wand-, Decken- oder Bodenoberfläche geschaffen werden, die leicht rein zu halten und möglichst strapazierfähig ist.

Zur Lösung der Aufgabe wird das Verfahren mit den Merkmalen des Anspruchs 1 vorgeschlagen. Vorteilhafte Weiterbildungen der Erfindung sind in den Unteransprüchen angegeben.

### Offenbarung der Erfindung

Erfindungsgemäß werden mehrere Schichten zur Beschichtung einer Gebäudeoberfläche, insbesondere einer Wand-, Decken- oder Bodenoberfläche, ausgebildet, die wenigstens eine wärmeableitende Schicht, eine Zwischenschicht und eine Deckschicht umfassen. Zur Ausbildung der Schichten werden viskose Beschichtungszusammensetzungen auf die Gebäudeoberfläche aufgebracht, wobei die lichtemittierenden Elemente in wenigstens eine Schicht integriert werden, so dass sie zumindest von der Deckschicht, die abschließend aufgebracht wird, vollständig überdeckt werden. Die mehreren Schichten können dabei in beliebiger Reihenfolge auf die Gebäudeoberfläche aufgebracht werden. Lediglich im Hinblick auf die Deckschicht ist festgelegt, dass diese als letzte Schicht aufgebracht wird, so dass diese außen liegend und die lichtemittierenden Elemente vollständig überdeckend eine Art Versiegelung ausbildet. Dies hat den Vorteil, dass beispielsweise OLEDs als lichtemittierende Elemente zum Einsatz gelangen können, die einen sehr einfachen Aufbau aufweisen und/oder nur eine Dünnschichtverkapselung besitzen. Die Dünnschichtverkapselung hat die Aufgabe, die organischen Schichten einer OLED vor Feuchtigkeit und Sauerstoff zu schützen. Da die Dünnschichtverkapselung aufgrund ihrer geringen Dicke darüber hinaus jedoch keine ausreichende mechanische Stabilität besitzt, muss diese zusätzlich vor mechanischen Schäden geschützt werden. Bekannt sind daher OLED-Anordnungen hinter Glas. Erfindungsgemäß wird der Schutz der lichtemittierenden Elemente vor mechanischen und/oder chemischen Einwirkungen im Wesentlichen durch die abschließende Deckschicht bewirkt. Die Deckschicht bildet dabei eine ebene Wand-, Decken- oder Bodenoberfläche aus, die leicht rein zu halten und zu pflegen ist. Auf diese Weise können flächige Beleuchtungsanordnungen geschaffen werden, die selbst Reinraumkriterien erfüllen oder zumindest erhöhten Hygiene- und Sauberkeitsansprüchen genügen.

Die lichtemittierenden Elemente werden vorteilhafterweise derart in die Beschichtung integriert, dass diese in Kontakt mit der wärmeableitenden Schicht stehen bzw. gebracht werden. Der Kontakt sollte möglichst großflächig, vorzugsweise vollflächig bewirkt werden. Beispielsweise kann eine rückseitige Oberfläche der lichtemittierenden Elemente vollflächig in Kontakt mit der wärmeableitenden Schicht stehen. Die wärmeableitende Schicht gewährleistet eine zuverlässige Ableitung der von den lichtemittierenden Elementen abgegebenen Wärme.

Neben der genannten wärmeableitenden Schicht, der Zwischenschicht und der Deckschicht können weitere Schichten, insbesondere Zwischen- und/oder Effektschichten auf die Gebäudeoberfläche - unterhalb der Deckschicht - aufgebracht werden. Der Aufbau einer nach einem erfindungsgemäßen Verfahren aufgebrachten Beschichtung ist jedoch zumindest dreischichtig. Der Auftrag einer nachfolgenden Schicht erfolgt erst nach vollständigem Aushärten der zuvor aufgetragenen Schicht. Die in wenigstens einer Schicht der Beschichtung integrierten lichtemittierenden Elemente kommen dabei ganz oder teilweise in wenigstens einer Schicht zum Liegen.

Bevorzugt wird zur Ausbildung wenigstens einer Schicht eine viskose Beschichtungszusammensetzung verwendet, die auf einem zweikomponentigen Reaktiv-Polymerbindemittel, vorzugsweise Epoxidharz oder Polyurethan, basiert. Derartige Beschichtungszusammensetzungen können aufgrund ihrer Haftkraft zur Befestigung der lichtemittierenden Elemente auf der Gebäudeoberfläche eingesetzt werden. Nach dem Aushärten bildet die Beschichtungszusammensetzung eine matrixähnliche, feste Schicht aus, in welche die lichtemittierenden Elemente zumindest teilweise eingebunden sind. Bei der Beschichtung einer Bodenoberfläche kann beispielsweise eine Beschichtungszusammensetzung auf Basis eines 2K-Polymerbindemittels als Vergussmasse eingesetzt werden. Die Ausbildung der Schicht und die Integration der lichtemittierenden Elemente erfolgt dann in der Weise, dass diese zunächst auf der Bodenoberfläche angeordnet und anschließend mittels der Beschichtungszusammensetzung vergossen werden. Das Aufbringen vorhergehender und/oder nachfolgender Schichten kann in gleicher Weise erfolgen. Zudem können einer Beschichtungszusammensetzung auf Basis eines 2K-Polymerbindemittels Additive und/oder Füllstoffe zugegeben werden, um die Materialeigenschaften zu verändern und/oder einer hieraus ausgebildeten Schicht eine bestimmte Wirkung zu verleihen. 2K-Polymerbindemittel, insbesondere Epoxidharze, ermöglichen zudem die Ausbildung weitgehend transparenter oder zumindest transluzenter Schichten, so dass sie das von den lichtemittierenden Elementen emittierte Licht hindurch lassen. Die Transparenz bzw. Transluzenz einer aus einer solchen Beschichtungszusammensetzung ausgebildeten Schicht hängt des Weiteren von der Art und der Menge etwaiger zugegebener Additive und/oder Füllstoffe ab.

Da Beschichtungszusammensetzungen der vorstehend genannten Art bei IR- und/oder UV-Bestrahlung zu Verfärbungen, insbesondere zu Vergilbungen, neigen, werden bevorzugt OLEDs als lichtemittierende Elemente in die vorgeschlagene Beschichtung integriert. Denn OLEDs emittieren keine IR- oder UV-Strahlung, so dass die Gefahr von Verfärbungen, insbesondere Vergilbungen, nicht besteht.

Weiterhin bevorzugt wird zur Ausbildung einer wärmeableitenden Schicht eine viskose Beschichtungszusammensetzung verwendet, der zur Steigerung der Wärmeleitfähigkeit der hieraus ausgebildeten Schicht Additive, insbesondere Pigmente, wie beispielsweise Kohlenstoffe, Carbide, Nitride, Metalle und/oder Halbmetalle und/oder deren Oxide und/oder Additive tragende Trägerstoffe, zugegeben worden sind. Dadurch kann die Funktionalität der wärmeableitenden Schicht erhöht werden, d. h., dass diese Schicht die von den lichtemittierenden Elementen erzeugte Wärme noch besser ableiten kann. Diese Maßnahme trägt zur Erhöhung der Lebensdauer der lichtemittierenden Elemente bei. Vorzugsweise beträgt der Anteil der Additive 0,1-20 Gew.-%, weiterhin vorzugsweise 0,5-15 Gew.-%, besonders bevorzugt 1,0-10 Gew.-% bezogen auf das Gesamtgewicht der Ausgangsstoffe der viskosen, d. h. der noch nicht ausgehärteten bzw. verarbeitungsfertigen Beschichtungszusammensetzung.

Ferner bevorzugt wird zur Ausbildung der wärmeableitenden Schicht eine viskose Beschichtungszusammensetzung verwendet, die nach dem Aushärten eine Wärmeleitfähigkeit λ > 1 W/(m*K), vorzugsweise λ > 2 W/(m*K), weiterhin vorzugsweise λ > 4 W/(m*K) besitzt. Das heißt, dass die aus der viskosen Beschichtungszusammensetzung ausgebildete wärmeableitende Schicht eine entsprechende Wärmeleitfähigkeit λ besitzt.

Zur Ausbildung der Zwischenschicht wird bevorzugt eine viskose Beschichtungszusammensetzung verwendet, der zur Erzielung einer bestimmten optischen Wirkung der hieraus ausgebildeten Schicht Pigmente und/oder Füllstoffe, insbesondere Farb- und/oder Effektpigmente, Carbonate, Sulfate und/oder Silikate, zugegeben worden sind. Die Zwischenschicht bildet vorzugsweise die unterhalb der Deckschicht zu liegen kommende Schicht aus, die in Abhängigkeit von der Transparenz oder Transluzenz der Deckschicht somit zumindest teilweise sichtbar bleibt. Die Zwischenschicht kann durch Zugabe von Pigmenten eingefärbt oder durch Zugabe von Füllstoffen strukturiert werden. Über ist die Zugabe von Effektpigmenten lassen sich beispielsweise Glanzeffekte erzeugen. Der Anteil der zugegebenen Pigmente und/oder der Füllstoffe beträgt vorzugsweise 1-70 Gew.-%, weiterhin vorzugsweise 2-60 Gew.-%, besonders bevorzugt 3-50 Gew.-% bezogen auf das Gesamtgewicht der Ausgangsstoffe der viskosen Beschichtungszusammensetzung. Des Weiteren bevorzugt dient die Zwischenschicht als feste Matrix, in welcher die lichtemittierenden Elemente vorrangig eingebettet sind. Das schließt nicht aus, dass die lichtemittierenden Elemente darüber hinaus in wenigstens eine weitere, an die Zwischenschicht angrenzende Schicht hineinragen.

Zur Ausbildung der Deckschicht wird weiterhin bevorzugt eine viskose Beschichtungszusammensetzung verwendet, der zur Erhöhung der mechanischen und/oder chemischen Stabilität und/oder zur Erzielung einer bestimmten optischen Wirkung der hieraus ausgebildeten Schicht Pigmente und/oder Füllstoffe, insbesondere Weiß-, Farb- und/oder Effektpigmente, carbonatische, sulfatische und/oder silikatische Füllstoffe, zugegeben worden sind. Der Deckschicht kommt die Aufgabe zu, die lichtemittierenden Elemente vor äußeren Einflüssen zu schützen, so dass diese eine hohe mechanische und/oder chemische Stabilität aufweisen sollte. Wird das Verfahren beispielsweise zur Beschichtung einer Bodenoberfläche eingesetzt, wobei die Beschichtung auch einen Fahrbahnbelag ausbilden kann, gilt es insbesondere die Abriebfestigkeit zu erhöhen. Ferner können Füllstoffe, wie beispielsweise Voll- oder Hohlglaskugeln, zur Ausbildung einer rutschhemmenden Oberfläche zugegeben werden. Die Zugabe kann auch nachträglich erfolgen. Es ist nicht zwingend erforderlich, dass die zugegebenen Füllstoffe transparent oder transluzent sind. In der Anwendung als Beschichtung einer Wand- oder Deckenoberfläche liegt der Schwerpunkt auf der Erzielung besonderer optischer Effekte, welche beispielsweise durch Zugabe von Pigmenten, insbesondere von Effektpigmenten, und/oder lichtstreuender Partikel erzielbar sind. Zudem sollte die Oberfläche möglichst glatt sein, um diese leicht zu reinigen. Der Anteil der Pigmente und/oder der Füllstoffe beträgt vorzugsweise 0-60 Gew.-%, weiterhin vorzugsweise 0-50 Gew.-%, besonders bevorzugt 0-40 Gew.-% bezogen auf das Gesamtgewicht der Ausgangsstoffe der viskosen Beschichtungszusammensetzung.

Bevorzugt wird die viskose Beschichtungszusammensetzung zur Ausbildung der wärmeableitenden Schicht und/oder der Zwischenschicht in einer Schichtstärke aufgebracht, so dass die Trockenschichtstärke der jeweiligen Schicht 0,1-3 mm, vorzugsweise 0,1-2,5 mm und weiterhin vorzugsweise 0,1-2 mm, beträgt.

Des Weiteren bevorzugt wird die viskose Beschichtungszusammensetzung zur Ausbildung der Deckschicht in einer Schichtstärke, so dass die Trockenschichtstärke der Deckschicht 0,05-2,5 mm, vorzugsweise 0,1-2 mm und weiterhin vorzugsweise 0,1-1,5 mm, beträgt.

Vorteilhafterweise werden die mehreren Schichten der wenigstens eine wärmeableitende Schicht, eine Zwischenschicht und eine Deckschicht umfassenden Beschichtung in Schichtstärken aufgebracht, so dass die Trockengesamtschichtstärke der Beschichtung 0,3-6 mm, vorzugsweise 0,5-5 mm und weiterhin vorzugsweise 0,7-4 mm, beträgt. Die Gesamtschichtstärke der Beschichtung ist demzufolge verhältnismäßig dünn, so dass von einer Dünnschichtbeschichtung gesprochen werden kann. Der Vorteil einer solchen Beschichtung ist, dass sie kaum aufträgt.

Das erfindungsgemäße Verfahren kann als weiteren Verfahrenschritt eine Vorbehandlung der zu beschichtenden Gebäudeoberfläche beinhalten. Insbesondere kann die Gebäudeoberfläche vor Aufbringen einer viskosen Beschichtungszusammensetzung zur Ausbildung einer Schicht geschliffen und/oder gesäubert werden. Das Erfordernis der Vorbehandlung hängt von der Beschaffenheit der Gebäudeoberfläche ab, welche den die Beschichtung aufnehmenden Untergrund ausbildet.

Alternativ oder ergänzend zur Vorbehandlung kann die Gebäudeoberfläche vor Aufbringen einer viskosen Beschichtungszusammensetzung zur Ausbildung einer Schicht grundiert und/oder gespachtelt werden. Auch dieser weitere Verfahrensschritt hängt von der Beschaffenheit der Gebäudeoberfläche ab. Da die Integration lichtemittierender Elemente in eine Beschichtung keinen besonders starken Schichtaufbau erfordert, die Gesamtschichtstärke kann beispielsweise weniger als 5 mm betragen, können sich unebene Untergründe nachteilig auf die Oberflächenqualität der hierauf ausgebildeten Beschichtung auswirken. Mittels einer zuvor ausgeführten Spachtelung können derartige Unebenheiten jedoch beseitigt werden. Ferner kann zur Spachtelung, d. h. zur Füllung von Löchern und/oder Hohlräumen der Gebäudeoberfläche eine Spachtelmasse verwendet werden, die vorzugsweise kostengünstiger als die hierauf aufzubringenden viskosen Beschichtungsmassen ist. Dies wirkt sich wiederum vorteilhaft auf die Herstellungskosten aus. Die Spachtelung ist als weitere Schicht im Sinne der vorliegenden Erfindung anzusehen. Gleiches gilt für eine etwaige Grundierung, die alternativ oder ergänzend zur Spachtelung auf die Gebäudeoberfläche aufgebracht werden kann. Die Funktion einer Grundierung liegt insbesondere darin, die Haftung der Beschichtung auf der Gebäudeoberfläche zu verbessern.

Gemäß einer bevorzugten Ausführungsform der Erfindung, insbesondere zur Beschichtung einer Bodenoberfläche, werden die lichtemittierenden Elemente einzeln oder in verdrahteter Anordnung auf die Gebäudeoberfläche oder eine hierauf aufgebrachte Grundierung, Spachtelung oder Schicht aufgelegt und mittels einer viskosen Beschichtungszusammensetzung vergossen. Um nicht jedes lichtemittierende Element einzeln zur Stromversorgung verdrahten zu müssen, wird eine Anordnung mehrerer solcher Elemente, die untereinander bereits verdrahtet sind, bevorzugt eingesetzt. Beispielsweise können die mehreren Elemente eine Matte ausbilden, die auf der Gebäudeoberfläche, die Grundierung, die Spachtelung oder eine Schicht aufgelegt wird. In dieser Anordnung können die lichtemittierenden Elemente in Reihe oder seriell geschaltet sein. Ferner kann die Anordnung Elemente umfassen, die Licht unterschiedlicher Farbe emittieren und somit gemeinsam ein Muster oder ein Bild wiedergeben.

Alternativ wird insbesondere zur Beschichtung einer Wand- oder Deckenoberfläche vorgeschlagen, dass die lichtemittierenden Elemente einzeln oder in verdrahteter Anordnung in eine auf die Gebäudeoberfläche, eine Grundierung und/oder Spachtelung aufgebrachte und noch nicht vollständig ausgehärtete Schicht eingelegt und mittels einer viskosen Beschichtungszusammensetzung eingeputzt werden. Wobei der Begriff "Einputzen" nicht die Verwendung einer Putzmasse im herkömmlichen Sinne bezeichnet, sondern die Verwendung einer viskosen Beschichtungszusammensetzung im Sinne der vorliegenden Erfindung. Eine herkömmliche Putzmasse, die hydraulische Bindemittel umfasst und mit Wasser angesetzt werden muss, würde zu einer Beschädigung der lichtemittierenden Elemente, insbesondere der OLEDs, führen, die bekanntermaßen empfindlich gegenüber länger einwirkender Feuchtigkeit und Sauerstoff sind. Vorliegend gelangen jedoch zweikomponentige Reaktivbindemittel in den viskosen Beschichtungszusammensetzungen zum Einsatz, so dass eine Beschädigung der lichtemittierenden Elemente nicht zu befürchten ist. Das Gegenteil ist der Fall. Die aus den viskosen Beschichtungszusammensetzungen ausgebildeten Schichten dienen als Schutzschichten, welche die lichtemittierenden Elemente vor äußeren Einflüssen schützen. Beim Einlegen der lichtemittierenden Elemente in eine Schicht, werden diese bevorzugt leicht angedrückt, so dass sie in die Schicht eindringen. Dadurch ist zumindest eine temporäre Befestigung der Elemente gewährleistet, bis diese vollständig von der nachfolgenden oder den nachfolgenden Schichten abgedeckt werden. Die Einbringtiefe in eine Schicht kann dabei beliebig gewählt werden. Beispielsweise können die Elemente auch vollständig in eine Schicht, beispielsweise die Zwischenschicht, hineingedrückt werden. Die außen liegende Oberfläche der Elemente kann dabei zunächst frei von der viskosen Beschichtungszusammensetzung bleiben oder von dieser überdeckt werden.

Beim Auf- oder Einlegen der lichtemittierenden Elemente werden diese bevorzugt systematisch angeordnet und/oder ausgerichtet. Dies gilt insbesondere, wenn die in die Beschichtung integrierten lichtemittierenden Elemente im Betriebszustand ein bestimmtes Muster oder ein bestimmtes Bild wiedergeben sollen. Das Ausrichten kann beispielsweise mittels einer Wasserwaage erfolgen. Ferner können vorgefertigte Schablonen zur Ausbildung eines Musters eingesetzt werden. Die Schablonen können zudem als temporäre Schutzschicht dienen, wenn sie beispielsweise in Form von Folien auf die lichtemittierenden Elemente aufgelegt werden.

Bei einzeln oder mehrfach verdrahteten lichtemittierenden Elementen gilt es ferner eine Verbindung zu einer Stromversorgung herzustellen. Die Stromversorgung der lichtemittierenden Elemente kann jedoch auch über elektrisch leitfähige Schichten hergestellt werden. Gemäß einer besonders bevorzugten Ausführungsform der Erfindung wird daher zur Ausbildung einer solchen Schicht eine viskose Beschichtungszusammensetzung verwendet, der leitfähige Substanzen, insbesondere Graphit und/oder Leitruß, zugegeben worden ist. Der Anteil der leitfähigen Substanzen beträgt vorzugsweise 3-50 Gew.-%, weiterhin vorzugsweise 4-40 Gew.-%, besonders bevorzugt 5-30 Gew.-% bezogen auf das Gesamtgewicht der Ausgangsstoffe der viskosen Beschichtungszusammensetzung.

Vorzugsweise werden zwei elektrisch leitfähige Schichten ausgebildet, zwischen denen eine Isolationsschicht angeordnet wird. Als elektrisch leitfähige Schicht können beispielsweise die wärmeableitende Schicht und die Zwischenschicht dienen, zwischen denen eine isolierende Zwischenschicht ausgebildet wird. Die Anordnung und Ausrichtung der lichtemittierenden Elemente erfolgt dann bevorzugt in der Weise, dass die beiden außen liegenden Elektroden eines solchen Elements in Kontakt mit jeweils einer leitfähigen Schicht gelangen. Auf diese Weise ist eine aufwendige Verkabelung verzichtbar.

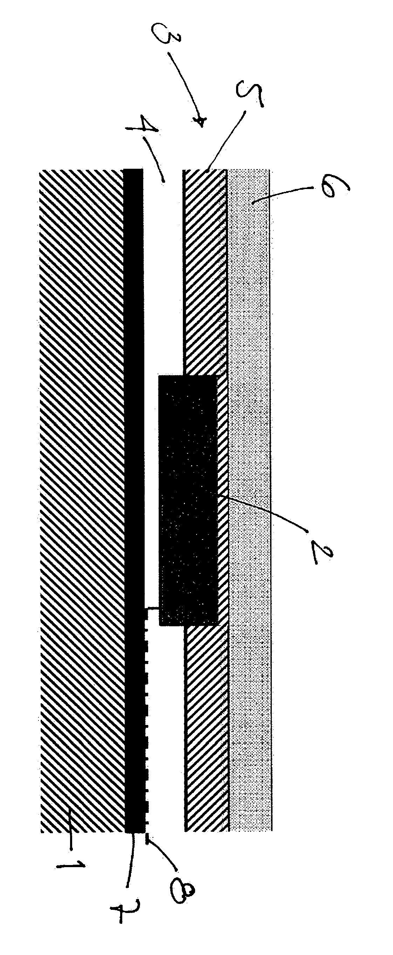

Das erfindungsgemäße Verfahren wird nachfolgend anhand der beigefügten Zeichnung näher beschrieben. Diese zeigt einen schematischen Querschnitt durch eine nach einem erfindungsgemäßen Verfahren ausgebildete Beschichtung einer Bodenoberfläche.

Die Schnittdarstellung zeigt eine Gebäudeoberfläche 1, wobei es sich vorliegend um eine Bodenoberfläche handelt, sowie eine nach dem erfindungsgemäßen Verfahren hergestellte Beschichtung 3, die im vorliegenden Beispiel eine unmittelbar auf der Gebäudeoberfläche 1 aufgebrachte Grundierung 7 als Haftvermittler, eine wärmeableitende Schicht 4, eine Zwischenschicht 5 und eine Deckschicht 6 umfasst. In die Beschichtung 3 ist ein lichtemittierendes Element 2 in Form einer organischen lichtemittierenden Diode integriert. Das lichtemittierende Element 2 ist vollständig in die wärmeableitende Schicht 4 und die Zwischenschicht 5 eingebettet. Die Stromversorgung des lichtemittierenden Elements 2 erfolgt über eine Verdrahtung 8.

Zur Ausbildung der wärmeableitenden Schicht 4 wurde vorliegend eine ZweiKomponenten-Epoxidharz Formulierung verwendet, umfassend Quarzmehl sowie die Wärmeleitfähigkeit steigernde Additive und/oder Füllstoffe. Vor dem vollständigen Aushärten der Schicht 4 wurde das lichtemittierende Element 2 einschließlich der Verdrahtung 8 auf die Schicht 4 aufgelegt und in die Schicht 4 hineingedrückt, so dass es mit einer Hälfte seiner Bauhöhe über die Schicht 4 hinausragt. Nach dem Aushärten der Schicht 4 wurde eine dekorative Zwischenschicht 5 auf Basis einer ZweiKomponenten-Epoxidharz Formulierung aufgebracht, der zuvor Effektpigmente zugegeben worden sind. Die Zwischenschicht 5 wurde vergossen, so dass die Zwischenschicht 5 das lichtemittierende Element 2 vollständig überdeckt. Die eigentliche Schutzschicht wird jedoch von der Deckschicht 6 gebildet, die anschließend - nach dem vollständigen Aushärten der Zwischenschicht 5 - auf diese aufgebracht wurde. Zur Ausbildung der Deckschicht 6 wurde vorliegend eine Zwei-Komponenten-Polyurethan Formulierung verwendet, auf welcher vor dem vollständigen Aushärten Hohlglaskugeln als rutschhemmende Füllstoffe aufgestreut wurden. Die Deckschicht 6 bildet eine mechanisch und chemisch belastbare Abschlussschicht bzw. Versiegelung aus, die darüber hinaus den häufig bestehenden Anforderungen an Bodenbelägen in öffentlichen Gebäuden im Hinblick auf eine rutschhemmende Oberfläche gerecht wird. Die Beschichtung 3 kann somit auch im Bereich von Treppen eingesetzt werden. Das in die Beschichtung 3 integrierte lichtemittierende Element 2 bewirkt zusätzlich eine Beleuchtung, so dass dem Sicherheitsaspekt auch dadurch Rechnung getragen wird.

Nachfolgend werden Beispiele viskoser Beschichtungszusammensetzungen genannt, die in dem erfindungsgemäßen Verfahren zur Ausbildung einer Schicht verwendet werden können.

### Beispiel 1

### (wärmeableitende Schicht auf Epoxidharz-Basis)

| **Komponente A:** | gefüllte Härter-Komponente |
|---|---|
| 41,0 Gew.-% | Wasser |
| 29,0 Gew.-% | Amin-Härter |
| 4,0 Gew.-% | Siliciumcarbid als wärmeableitendes Additiv |
| 3,0 Gew.-% | Leitruß und/oder Graphit als wärmeableitendes Additiv |
| 2,0 Gew.-% | Kohlenstoff-Fasern als wärmeableitendes Additiv |
| 16,0 Gew.-% | Füllstoffe wie BaSO₄ und SiO₂ |
| 5,0 Gew.-% | Additive wie Netzmittel, Entschäumer, Oberflächen- und Verlaufsadditive |
| | |
| **Komponente B:** | Epoxidharz-Mischung |
| 60,0 Gew.-% | Epoxidharz A |
| 30,0 Gew.-% | Epoxidharz F |
| 10 Gew.-% | Epoxid-Reaktiwerdünner |

Das Mischungsverhältnis der Komponente A zur Komponente B beträgt 100 zu 22 Gew.-Teile. Die Auftragung kann bis zu einer Schichtstärke von 3 mm erfolgen, besser jedoch maximal 2 mm.

Die Wärmleitfähigkeit einer hieraus hergestellten Schicht beträgt 8 W/(m*K) ± 2 W/(m*K), bestimmt am freien Film mit einem HotDisk TPS25006-Gerät mit Thin-Film-Modul.

### Beispiel 2

### (wärmeableitende Schicht auf Polyurethan-Basis)

| | |
|---|---|
| **Komponente A:** | gefüllte Polyol-Komponente |
| 45,0 Gew.-% | verzweigte aliphatische Polyole |
| 7,0 Gew.-% | Aluminiumnitrid als wärmeableitendes Additiv |
| 0,5 Gew.-% | Kohlenstoff-Fasern als wärmeableitendes Additiv |
| 42,0 Gew.-% | Füllstoffe wie BaSO₄, CaCO₃ und Quarz |
| 5,0 Gew.-% | Zeolithe /Molsieb |
| 0,5 Gew.-% | Additive wie Netzmittel, Entlüfter, Beschleuniger, Thixotropiermittel |
| | |
| **Komponente B:** | Isocyanat-Komponente |
| 100,0 Gew.-% | aliphatisches Polyisocyanat |

Das Mischungsverhältnis der Komponente A zur Komponente B beträgt 100 zu 33 Gew.-Teile. Die Auftragung kann bis zu einer Schichtstärke von 3 mm erfolgen, besser jedoch maximal 2 mm.

Die Wärmleitfähigkeit einer hieraus hergestellten Schicht beträgt 7 W/(m*K) ± 2 W/(m*K), bestimmt am freien Film mit einem HotDisk TPS25006-Gerät mit Thin-Film-Modul.

### Beispiel 3

### (Zwischenschicht auf Epoxidharz-Basis)

| **Komponente A:** | gefüllte Härter-Komponente |
|---|---|
| 14,0 Gew.-% | Wasser |
| 17,0 Gew.-% | Amin-Härter |
| 5,0 Gew.-% | Weißpigment TiO₂ |
| 63,0 Gew.-% | Füllstoffe wie BaSO₄, Carbonate und Quarz |
| 1,0 Gew.-% | Additive wie Netzmittel, Entschäumer, Oberflächen- und Verlaufsadditive |
| | |
| **Komponente B:** | Epoxidharz-Mischung |
| 59,0 Gew.-% | Epoxidharz A |
| 31,0 Gew.-% | Epoxidharz F |
| 10 Gew.-% | Epoxid-Reaktiwerdünner |

Das Mischungsverhältnis der Komponente A zur Komponente B beträgt 100 zu 12 Gew.-Teile. Die Auftragung kann bis zu einer Schichtstärke von 3 mm erfolgen, besser jedoch maximal 2 mm.

Die Wärmleitfähigkeit einer hieraus hergestellten Schicht war innerhalb der Messtoleranz nicht mehr bestimmbar.

### Beispiel 4

### (Zwischenschicht auf Polyurethan-Basis)

| | |
|---|---|
| **Komponente A:** | gefüllte Polyol-Komponente |
| 35,0 Gew.-% | verzweigte aliphatische Polyole |
| 10,0 Gew.-% | hydroxylgruppenhaltige Polyester |
| 49,0 Gew.-% | Füllstoffe wie BaSO₄, Carbonate und Quarz |
| 5,0 Gew.-% | Zeolithe /Molsieb |
| 1,0 Gew.-% | Additive wie Netzmittel, Entlüfter, Beschleuniger, Thixotropiermittel |
| | |
| **Komponente B:** | Isocyanat-Komponente |
| 100,0 Gew.-% | aliphatisches Polyisocyanat |

Das Mischungsverhältnis der Komponente A zur Komponente B beträgt 100 zu 32 Gew.-Teile. Die Auftragung kann bis zu einer Schichtstärke von 3 mm erfolgen, besser jedoch maximal 2 mm. Nach dem Beschichtungsauftrag können zudem 1 mm große mehrfarbige Acrylat-Chips in die noch frische Beschichtung dekorativ eingestreut werden.

### Beispiel 5

### (Deckschicht / Versiegelung auf Epoxidharz-Basis)

| **Komponente A:** | gefüllte Härter-Komponente |
|---|---|
| 32,0 Gew.-% | Wasser |
| 26,5 Gew.-% | Amin-Härter |
| 25,0 Gew.-% | Weißpigment TiO₂ |
| 15,0 Gew.-% | Füllstoffe wie BaSO₄ und Quarz |
| 1,5 Gew.-% | Additive wie Netzmittel, Entschäumer, Oberflächen- und Verlaufsadditive |
| | |
| **Komponente B:** | Epoxidharz-Mischung |
| 62,0 Gew.-% | Epoxidharz A |
| 26,0 Gew.-% | Epoxidharz F |
| 12,0 Gew.-% | Epoxid-Reaktiwerdünner |

Das Mischungsverhältnis der Komponente A zur Komponente B beträgt 100 zu 20 Gew.-Teile. Die Auftragung kann bis zu einer Schichtstärke von 2 mm erfolgen, besser jedoch maximal 1 mm.

### Beispiel 6

### (Deckschicht / Versiegelung auf Polyurethan-Basis)

| **Komponente A:** | |
|---|---|
| 58,0 Gew.-% | vernetzbares Polyacrylat |
| 32,0 Gew.-% | Wasser |
| 10,0 Gew.-% | Additive wie Entschäumer, Stabilisatoren, Filmbildehilfsmittel, Oberflächen- und Verlaufsadditive |
| **Komponente B:** | Isocyanat-Komponente |
| 100,0 Gew.-% | Polyisocyanat auf HMDI-Basis |

Das Mischungsverhältnis der Komponente A zur Komponente B beträgt 100 zu 22 Gew.-Teile. Die Auftragung kann bis zu einer Schichtstärke von 0,5 mm erfolgen, besser jedoch maximal 0,3 mm. Nach dem Beschichtungsauftrag können Hohlglaskugeln mit mittlerem Durchmesser von 0,25 mm bis 0,4 mm auf die noch frische Beschichtung als Rutschhemmung gestreut werden.

## Patentansprüche

1. Verfahren zur Beschichtung einer Gebäudeoberfläche (1), insbesondere einer Wand-, Decken- oder Bodenoberfläche eines Gebäudes, bei welchem lichtemittierende Elemente (2), insbesondere organische lichtemittierende Dioden, in die Beschichtung (3) integriert werden,
**dadurch gekennzeichnet, dass** mehrere Schichten (4, 5, 6) ausgebildet werden, die wenigstens eine wärmeableitende Schicht (4), eine Zwischenschicht (5) und eine Deckschicht (6) umfassen, so dass der Aufbau der Beschichtung zumindest dreischichtig ist, und zur Ausbildung der mehreren Schichten (4, 5, 6) viskose Beschichtungszusammensetzungen auf die Gebäudeoberfläche (1) aufgebracht werden, wobei der Auftrag einer nachfolgenden Schicht erst nach vollständigem Aushärten der zuvor aufgetragenen Schicht erfolgt und wobei die lichtemittierenden Elemente (2) in wenigstens eine Schicht (4, 5, 6) integriert werden, so dass sie zumindest von der Deckschicht (6), die abschließend aufgebracht wird, vollständig überdeckt werden.

2. Verfahren nach Anspruch 1,
**dadurch gekennzeichnet, dass** zur Ausbildung wenigstens einer Schicht (4, 5, 6) eine viskose Beschichtungszusammensetzung verwendet wird, die auf einem zweikomponentigen Reaktiv-Polymerbindemittel, vorzugsweise Epoxidharz oder Polyurethan, basiert.

3. Verfahren nach Anspruch 1 oder 2,
**dadurch gekennzeichnet, dass** zur Ausbildung der wärmeableitenden Schicht (4) eine viskose Beschichtungszusammensetzung verwendet wird, der zur Steigerung der Wärmeleitfähigkeit der hieraus ausgebildeten Schicht (4) Additive, insbesondere Pigmente, wie beispielsweise Kohlenstoffe, Carbide, Nitride, Metalle und/oder Halbmetalle und/oder deren Oxide, und/oder Additive tragende Trägerstoffe zugegeben worden sind, wobei der Anteil der Additive vorzugsweise 0,1-20 Gew.-%, weiterhin vorzugsweise 0,5-15 Gew.-%, besonders bevorzugt 1,0-10 Gew.-% bezogen auf das Gesamtgewicht der Ausgangsstoffe der viskosen Beschichtungszusammensetzung beträgt.

4. Verfahren nach einem der vorhergehenden Ansprüche,
**dadurch gekennzeichnet, dass** zur Ausbildung der wärmeableitenden Schicht (4) eine viskose Beschichtungszusammensetzung verwendet wird, die nach dem Aushärten eine Wärmeleitfähigkeit (λ) > 1 W/(m*K), vorzugsweise (λ) > 2 W/(m*K), weiterhin vorzugsweise (λ) > 4 W/(m*K) besitzt.

5. Verfahren nach einem der vorhergehenden Ansprüche,
**dadurch gekennzeichnet, dass** zur Ausbildung der Zwischenschicht (5) eine viskose Beschichtungszusammensetzung verwendet wird, der zur Erzielung einer bestimmten optischen Wirkung der hieraus ausgebildeten Schicht Pigmente und/oder Füllstoffe, insbesondere Farb- und/oder Effektpigmente, Carbonate, Sulfate und/oder Silikate, zugegeben worden sind, wobei der Anteil der Pigmente und/oder der Füllstoffe vorzugsweise 1-70 Gew.-% weiterhin vorzugsweise 2-60 Gew.-%, besonders bevorzugt 3-50 Gew.-% bezogen auf das Gesamtgewicht der Ausgangsstoffe der viskosen Beschichtungszusammensetzung beträgt.

6. Verfahren nach einem der vorhergehenden Ansprüche,
**dadurch gekennzeichnet, dass** zur Ausbildung der Deckschicht (6) eine viskose Beschichtungszusammensetzung verwendet wird, der zur Erhöhung der mechanischen und/oder chemischen Stabilität und/oder zur Erzielung einer bestimmten optischen Wirkung der hieraus ausgebildeten Schicht (6) Pigmente und/oder Füllstoffe, insbesondere Weiß-, Farb- und/oder Effektpigmente, carbonatische, sulfatische und/oder silikatische Füllstoffe zugegeben worden sind, wobei der Anteil der Pigmente und/oder der Füllstoffe vorzugsweise 0-60 Gew.-%, weiterhin vorzugsweise 0-50 Gew.-%, besonders bevorzugt 0-40 Gew.-% bezogen auf das Gesamtgewicht der Ausgangsstoffe der viskosen Beschichtungszusammensetzung beträgt.

7. Verfahren nach einem der vorhergehenden Ansprüche,
**dadurch gekennzeichnet, dass** die viskose Beschichtungszusammensetzung zur Ausbildung der wärmeableitenden Schicht (4) und/oder der Zwischenschicht (5) in einer Schichtstärke aufgebracht wird, so dass die Trockenschichtstärke 0,1-3 mm, vorzugsweise 0,1-2,5 mm und weiterhin vorzugsweise 0,1-2 mm, beträgt.

8. Verfahren nach einem der vorhergehenden Ansprüche,
**dadurch gekennzeichnet, dass** die viskose Beschichtungszusammensetzung zur Ausbildung der Deckschicht (6) in einer Schichtstärke aufgebracht wird, so dass die Trockenschichtstärke 0,05-2,5 mm, vorzugsweise 0,1-2 mm und weiterhin vorzugsweise 0,1-1,5 mm, beträgt.

9. Verfahren nach einem der vorhergehenden Ansprüche,
**dadurch gekennzeichnet, dass** die mehreren Schichten (4, 5, 6) der Beschichtung (3) in Schichtstärken aufgebracht werden, so dass die Trockengesamtschichtstärke der Beschichtung (3) 0,3-6 mm, vorzugsweise 0,5-5 mm und weiterhin vorzugsweise 0,7-4 mm, beträgt.

10. Verfahren nach einem der vorhergehenden Ansprüche,
**dadurch gekennzeichnet, dass** die Gebäudeoberfläche (1) vor Aufbringen einer viskosen Beschichtungszusammensetzung zur Ausbildung einer Schicht (4, 5, 6) vorbehandelt, insbesondere geschliffen und/oder gesäubert, wird.

11. Verfahren nach einem der vorhergehenden Ansprüche,
**dadurch gekennzeichnet, dass** die Gebäudeoberfläche (1) vor Aufbringen einer viskosen Beschichtungszusammensetzung zur Ausbildung einer Schicht (4, 5, 6) grundiert und/oder gespachtelt wird.

12. Verfahren nach einem der vorhergehenden Ansprüche,
**dadurch gekennzeichnet, dass** die lichtemittierenden Elemente (2) einzeln oder in verdrahteter Anordnung auf die Gebäudeoberfläche (1) oder eine hierauf aufgebrachte Grundierung (7), Spachtelung oder Schicht (4, 5) aufgelegt und mittels einer viskosen Beschichtungszusammensetzung vergossen werden.

13. Verfahren nach einem der Ansprüche 1 bis 10,
**dadurch gekennzeichnet, dass** die lichtemittierenden Elemente (2) einzeln oder in verdrahteter Anordnung in eine auf die Gebäudeoberfläche (1), eine Grundierung (7) und/oder Spachtelung aufgebrachte und noch nicht vollständig ausgehärtete Schicht (4, 5) eingelegt und mittels einer viskosen Beschichtungszusammensetzung eingeputzt werden.

14. Verfahren nach Anspruch 11 oder 12,
**dadurch gekennzeichnet, dass** die lichtemittierenden Elemente (2) systematisch angeordnet und/oder ausgerichtet werden.

15. Verfahren nach einem der vorhergehenden Ansprüche,
**dadurch gekennzeichnet, dass** zur Ausbildung einer Schicht (4, 5, 6) eine viskose Beschichtungszusammensetzung verwendet wird, der leitfähige Substanzen, insbesondere Graphit und/oder Leitruß, zugegeben worden ist, wobei der Anteil der leitfähigen Substanzen vorzugsweise 3-50 Gew.-%, weiterhin vorzugsweise 4-40 Gew.-%, besonders bevorzugt 5-30 Gew.-% bezogen auf das Gesamtgewicht der Ausgangsstoffe der viskosen Beschichtungszusammensetzung beträgt.

## Claims

1. A method for coating a building surface (1), particularly a wall, ceiling or floor surface of a building, in which light-emitting elements (2), particularly organic light emitting diodes, are integrated in the coating (3),
**characterized in that** multiple layers (4, 5, 6) are formed and comprise at least one heat dissipating layer (4), one intermediate layer (5) and one cover layer (6), so that the structure of the coating consists of at least three layers, and viscous coating compositions are applied to the building surface (1) to form the multiple layers (4, 5, 6), wherein a subsequent layer is not applied until the layer applied previously has cured completely, and wherein the light emitting elements (2) are integrated in at least one layer (4, 5, 6) so that they are completely covered at least by the cover layer (6) which is applied as the final step.

2. The method according to claim 1,
**characterized in that** a viscous coating compound that is based on a two-component reactive polymer binder, preferably epoxy resin or polyurethane, is used to form at least one layer (4, 5, 6).

3. The method according to claim 1 or 2,
**characterized in that** in order to form the heat dissipating layer (4) a viscous coating compound is used to which additives, particularly pigments, such as carbons, carbides, nitrides, metals and/or semimetals and/or the oxides thereof and/or
carrier substances that carry the additives have been added to increase the thermal conductivity of the layer (4) formed therefrom, wherein the proportion of additives is preferably 0.1 to 20 % by wt., more preferably 0.5 to 15 % by wt., particularly preferably 1.0 to 10 % by wt., relative to the total weight of the starting materials of the viscous coating compound.

4. The method according to any one of the preceding claims,
**characterized in that** a viscous coating compound which has a thermal conductivity (λ)> 1 W/(m*K), preferably (λ)> 2 W/(m*K), and still more preferably (λ)> 4 W/(m*K) after curing is used to form the heat dissipating layer (4).

5. The method according to any one of the preceding claims,
**characterized in that** a viscous coating compound to which pigments and/or fillers, particularly coloured and/or effect pigments, carbonates, sulphates and/or silicates have been added in order to achieve a particular optical effect of the layer formed therefrom, wherein the proportion of the pigments and/or fillers is preferably 1 to 70 % by wt. more preferably 2 to 60 % by wt., particularly preferably 3 to 50 % by wt., relative to the total weight of the starting materials of the viscous coating compound, is used to form the intermediate layer (5).

6. The method according to any one of the preceding claims,
**characterized in that** a viscous coating compound to which pigments and/or fillers, particularly white, coloured and/or effect pigments, carbonatic, sulphatic and/or silicatic filler have been added in order to increase the mechanical and/or chemical stability and/or to achieve a certain optical effect in the layer (6) formed therefrom, wherein the proportion of the pigments and/or fillers is preferably 0 to 60 by wt. more preferably 0 to 50 % by wt., particularly preferably 0 to 40 % by wt., relative to the total weight of the starting materials of the viscous coating compound, is used to form the cover layer (6).

7. The method according to any one of the preceding claims,
**characterized in that** the viscous coating compound is applied in such a layer thickness that the dry film thickness is 0.1 to 3 mm, preferably 0.1 to 2.5 mm, and more preferably 0.1 to 2 mm to form the heat dissipating layer (4) and/or the intermediate layer (5).

8. The method according to any one of the preceding claims,
**characterized in that** the viscous coating compound is applied in such a layer thickness that the dry film thickness is 0.05 to 2.5 mm, preferably 0.1 to 2 mm, and further preferably 0.1 to 1.5 mm to form the cover layer (6).

9. The method according to any one of the preceding claims,
**characterized in that** the multiple layers (4, 5, 6) of the coating (3) are applied in such layer thicknesses that the dry film thickness of the coating (3) is 0.03 to 6 mm, preferably 0.5 to 5 mm, and further preferably 0.7 to 4 mm.

10. The method according to any one of the preceding claims,
**characterized in that** the building surface (1) is pre-treated, particularly polished and/or cleaned, prior to the application of a viscous coating compound to form a layer (4, 5, 6).

11. The method according to any one of the preceding claims,
**characterized in that** the building surface (1) is primed and/or smoothed prior to the application of a viscous coating compound to form a layer (4, 5, 6).

12. The method according to any one of the preceding claims,
**characterized in that** the light emitting elements (2) are laid individually or in a wired arrangement on the building surface (1) and/or onto a priming (7) or smoothing coat or a layer (4, 5) applied thereto, and are embedded by pouring a viscous coating compound over them.

13. The method according to any one of claims 1 to 10,
**characterized in that** the light emitting elements (2) are laid individually or in a wired arrangement in a layer (4, 5) that has been applied on top of a priming (7) and/or smoothing coat applied to the building surface (1) and has not yet completely cured, and are plastered in by means of a viscous coating compound.

14. The method according to either of claims 11 or 12,
**characterized in that** the light emitting elements (2) are arranged and/or aligned systematically.

15. The method according to any one of the preceding claims,
**characterized in that** a viscous coating compound to which conductive substances, particularly graphite and/or carbon black have been added,
wherein the fraction of conductive substances is preferably 3 to 50 % by wt., more preferably 4 to 40 % by wt., particularly preferably 5 to 30 % by wt., relative to the total weight of the starting materials of the viscous coating compound, is used to form a layer (4, 5, 6).

## Revendications

1. Procédé destiné à revêtir une surface d'un bâtiment (1), notamment une surface de paroi, de plafond ou de sol d'un bâtiment, lors duquel on intègre des éléments (2) électroluminescents, notamment des diodes électroluminescentes organiques dans le revêtement (3),
**caractérisé en ce qu'**on créé plusieurs couches (4, 5, 6), qui comprennent au moins une couche (4) dissipatrice de chaleur, une couche intermédiaire (5) et une couche de finition (6), de sorte que la structure du revêtement soit au moins tricouches et pour la création des plusieurs couches, (4, 5, 6) on applique des compositions de revêtement visqueuses sur la surface du bâtiment (1), l'application d'une couche suivante ne s'effectuant qu'après un durcissement total de la couche précédemment appliquée et les éléments (2) électroluminescents étant intégrés dans au moins une couche (4, 5, 6), de sorte qu'ils soient au moins totalement recouverts par la couche de finition (6) que l'on applique pour terminer.

2. Procédé selon la revendication 1,
**caractérisé en ce que** pour créer au moins une couche (4, 5, 6), on utilise une composition de revêtement visqueuse qui est basée sur un agent liant polymère réactif bicomposants, de préférence de la résine époxy ou du polyuréthane.

3. Procédé selon la revendication 1 ou 2,
**caractérisé en ce que** pour créer la couche (4) dissipatrice de chaleur, on utilise une composition de revêtement visqueuse, à laquelle on a ajouté pour augmenter la conductibilité thermique de la couche (4) créée à partir de celle-ci des additifs, notamment des pigments, comme par exemple des carbones, des carbures, des nitrures, des métaux et/ou des semi-métaux et/ou leurs oxydes et/ou des supports portant les additifs, la part en additifs étant de préférence de 0,1 à 20 % en poids, de manière plus préférée de 0,5 à 15 % en poids, de manière particulièrement préférée de 1,0 à 10 % en poids, en rapport au poids total des substances initiales de la composition de revêtement visqueuse.

4. Procédé selon l'une quelconque des revendications précédentes,
**caractérisé en ce que** pour créer la couche (4) dissipatrice de chaleur, on utilise une composition de revêtement visqueuse, qui après le durcissement fait preuve d'une conductivité thermique de (λ)> 1 W (m*K), de préférence de (λ)> 2 W (m*K), de manière préférée par ailleurs de (λ) > 4 W (m*K).

5. Procédé selon l'une quelconque des revendications précédentes,
**caractérisé en ce que** pour créer la couche intermédiaire (5), on utilise une composition de revêtement visqueuse à laquelle, pour obtenir un certain effet visuel de la couche formée à partir de celle-ci, on a ajouté des pigments et/ou des agents de charge, notamment des pigments colorés et/ou à effets, des carbonates, des sulfates et/ou des silicates, la part des pigments et/ou des agents de charge étant de préférence de 1 à 70 % en poids, de manière préférée par ailleurs de 2 à 60 % en poids, de manière particulièrement préférée de 3 à 50 % en poids, en rapport au poids total des substances initiales de la composition de revêtement visqueuse.

6. Procédé selon l'une quelconque des revendications précédentes,
**caractérisé en ce que** pour créer la couche de finition (6), on utilise une composition de revêtement visqueuse, à laquelle, pour augmenter la stabilité mécanique et/ou chimique et/ou pour obtenir un certain effet visuel de la couche (6) créée à partir de celle-ci, on a ajouté des pigments et/ou des agents de charge, notamment des pigments blancs, colorés et/ou à effets, des agents de charge carbonatés, sulfatés et/ou silicatés, la part en pigments et/ou en agents de charge étant de préférence de 0 à 60 % en poids, de manière préférée par ailleurs de 0 à 50 % en poids, de manière particulièrement préférée de 0 à 40 % en poids, en rapport au poids total des substances initiales de la composition de revêtement visqueuse.

7. Procédé selon l'une quelconque des revendications précédentes,
**caractérisé en ce qu'**on applique la composition de revêtement visqueuse pour créer la couche (4) dissipatrice de chaleur et/ou la couche intermédiaire (5) sur une épaisseur de couche, de sorte que l'épaisseur de couche sèche soit de 0,1 à 3 mm, de préférence de 0,1 à 2,5 mm et de manière préférée par ailleurs de 0,1 à 2 mm.

8. Procédé selon l'une quelconque des revendications précédentes,
**caractérisé en ce qu'**on applique la composition de revêtement visqueuse pour créer la couche de finition (6) dissipatrice de chaleur sur une épaisseur de couche, de sorte que l'épaisseur de couche sèche soit de 0,05 à 2,5 mm, de préférence de 0,1 à 2 mm et de manière préférée par ailleurs de 0,1 à 1,5 mm.

9. Procédé selon l'une quelconque des revendications précédentes,
**caractérisé en ce qu'**on applique les plusieurs couches (4, 5, 6) du revêtement (3) sur des épaisseurs de couches, de sorte que l'épaisseur totale des couches sèches du revêtement (3) soit de 0,3 à 6 mm, de préférence de 0,5 à 5 mm et de manière préférée par ailleurs de 0,7 à 4 mm.

10. Procédé selon l'une quelconque des revendications précédentes,
**caractérisé en ce qu'**avant l'application d'une composition de revêtement visqueuse, pour créer une couche (4, 5, 6), on traite préalablement, notamment on ponce et/ou on nettoie la surface de bâtiment (1).

11. Procédé selon l'une quelconque des revendications précédentes,
**caractérisé en ce qu'**avant l'application d'une composition de revêtement visqueuse, pour créer une couche (4, 5, 6), on apprête et/ou on rebouche la surface de bâtiment (1).

12. Procédé selon l'une quelconque des revendications précédentes,
**caractérisé en ce qu'**on pose les éléments (2) électroluminescents un à un ou en placement en treillis sur la surface de bâtiment (1) ou sur un apprêt (7), un rebouchage ou une couche (4, 5) appliqué(e) sur cette dernière et on les scelle au moyen d'une composition de revêtement visqueuse.

13. Procédé selon l'une quelconque des revendications 1 à 10,
**caractérisé en ce qu'**on pose les éléments (2) électroluminescents un à un ou en placement en treillis sur une couche (4, 5) d'apprêt (7) et ou de rebouchage appliquée sur la surface de bâtiment (1) pas encore totalement séchée et on les intègre par crépi au moyen d'une composition de revêtement visqueuse.

14. Procédé selon la revendication 11 ou 12,
**caractérisé en ce qu'**on place systématiquement et/ou on oriente les éléments (2) électroluminescents.

15. Procédé selon l'une quelconque des revendications précédentes,
**caractérisé en ce que** pour créer une couche (4, 5, 6), on utilise une composition de revêtement visqueuse, à laquelle on a ajouté des substances conductrices, notamment du graphite et/ou du noir de carbone conducteur, la part en substances conductrices étant de préférence de 3 à 50 % en poids, de manière préférée par ailleurs de 4 à 40 % en poids, de manière particulièrement préférée de 5 à 30 % en poids, en rapport au poids total des substances initiales de la composition de revêtement visqueuse.
